Europäisches Patentamt

European Patent Office

Office européen des brevets

(19)

(11) **EP 0 715 335 A1**

(12) **EUROPEAN PATENT APPLICATION**

(43) Date of publication:
05.06.1996 Bulletin 1996/23

(51) Int. Cl.$^6$: **H01J 37/32**, H05H 1/46

(21) Application number: 96102011.2

(22) Date of filing: 20.01.1992

(84) Designated Contracting States:
**DE FR GB IT NL**

(30) Priority: 18.01.1991 US 644004

(62) Application number of the earlier application in
accordance with Art. 76 EPC: **92100845.4**

(71) Applicant: **APPLIED MATERIALS, INC.**
**Santa Clara California 95054-3299 (US)**

(72) Inventor: **Collins, Kenneth S.**
**San Jose, CA 95112 (US)**

(74) Representative: **DIEHL GLAESER HILTL &**
**PARTNER**
**Flüggenstrasse 13**
**80639 München (DE)**

Remarks:
This application was filed on 12 - 02 - 1996 as a
divisional application to the application mentioned
under INID code 62.

(54) **System for processing a workpiece in a plasma**

(57)     A system for processing a workpiece (5) in a
plasma comprises enclosure (11) defining a vacuum
processing chamber (16), electrode means (25, 32c) for
coupling AC electrical energy into the chamber to generate a plasma in the gas. High frequency VHF/UHF
electrical energy is applied to the electrode means (25,
32c) to control the density of the plasma and relatively
lower frequency AC electrical energy is applied to the
electrode means to control the sheath voltage appreci-
ated with the electrode means and plasma ion energy.
The electrode means preferably comprises two elec-
trode structures for applying the high frequency AC elec-
trical energy to the chamber.

FIG-1

EP 0 715 335 A1

**Description**

The present invention relates to a system for processing a workpiece in a plasma.

The trend toward increasingly dense integrated geometries has resulted in components and devices of very small geometry which are electrically sensitive and susceptible to damage when subjected to wafer sheath voltages as small as approximately 200-300 volts due to energetic particle bombardment or radiation. Unfortunately, such voltages are of smaller magnitude than the voltages to which the circuit components are subjected during standard integrated circuit fabrication processes.

Structures such as MOS capacitors and transistors-fabricated for advanced devices have very thin (thickness < 20 nm (200 Angstroms) ) gate oxides. These devices may be damaged by charge-up, resulting in gate breakdown. This can occur in a plasma process when neutralization of surface charge does not occur, by non-uniform plasma potential/or density, or by large RF displacement currents. Conductors such as interconnect lines may be similarly damaged.

RF Systems

Consider first prior art semiconductor processing systems such as CVD (chemical vapor deposition) and RIE (reactive ion etching) reactor systems. These systems may use radio frequency energy at low frequencies from about 10-500 Khz up to higher frequencies of about 13.56 - 40.68 Mhz. Below about 1 Mhz, ions and electrons can be accelerated by the oscillating electric field, and by any steady state electric field developed in the plasma. At such relatively low frequencies, the electrode sheath voltage produced at the wafers typically is up to one or more kilovolts peak, which is much higher than the damage threshold of 200-300 volts. Above several Mhz, electrons are still able to follow the changing electric field. More massive ions are not able to follow the changing field, but are accelerated by steady state electric fields. In this frequency range (and at practical gas pressures and power levels), steady state sheath voltages are in the range of several hundred volts to 1,000 volts or more.

Magnetic Field-Enhancement

A favorite approach for decreasing the bias voltage in RF systems involves applying a magnetic field to the plasma. This B field confines the electrons to the region near the surface of the wafer and increases the ion flux density and ion current and, thus, reduces the voltage and ion energy requirements. By way of comparison, an exemplary non-magnetic RIE process for etching silicon dioxide might use RF energy applied at 13.56 Mhz, an asymmetrical system of 10-15 liters volume, 65 * 10$^{-6}$ bar (50 millitorr) pressure an anode area to wafer-support cathode area ratio of approximately (8-10) to 1, and develop wafer (cathode) sheath voltage of approximately 800 volts. The application of a magnetic field of 60 gauss may decrease the bias voltage approximately 25-30 percent, from 800 volts to about 500-600 volts, while increasing the etch rate by as much as about 50 percent.

However, the application of a stationary **B** field parallel to the wafer develops an **E** x **B** ion/electron drift and an associated plasma density gradient which is directed diametrically across the wafer. The plasma gradient causes non-uniform etching, deposition and other film properties across the wafer. The non-uniformities may be decreased by rotating the magnetic field around the wafer, typically either by mechanical movement of permanent magnets, or by using pairs of electromagnetic cbils which are driven in quadrature, 90 degrees out of phase, or by instantaneously controlling the current in pairs of coils to step or otherwise move the magnetic field at a controlled rate. However, although rotating the field reduces the non-uniformity gradient, typically some degree of non-uniformity remains.

Furthermore, it is difficult to pack coils and, in particular, to pack two or more pairs of coils about a chamber and to achieve a compact system, especially when using a Helmholtz coil configuration and/or a multi-chamber system of individual magnetic-enhanced reactor chambers surrounding a common loadlock.

A unique reactor system which has the capability to instantaneously and selectively alter the magnetic field strength and direction, and which is designed for use in compact multi-chamber reactor systems, is disclosed in commonly assigned U.S. Patent 4,842,683, issued June 27, 1989, in the name of inventors Cheng et al.

Microwave/ECR Systems

Microwave and microwave ECR (electron cylotron resonance) systems use microwave energy of frequencies >800 MHz and, typically, frequencies of 2.45 GHz to excite the plasma. This technique produces a high density plasma, but low particle energies which may be below the minimum reaction threshold energy for many processes, such as the reactive ion etching of silicon dioxide. To compensate, energy-enhancing low frequency electrical power is coupled to the wafer support electrode and through the wafer to the plasma. Thus, the probability of wafer damage is decreased relative to previous systems.

Microwave and microwave ECR systems operated at practical power levels for semiconductor wafer processing such as etch or CVD require large waveguides for power transmission, and expensive tuners, directional couplers, circulators, and dummy loads for operation. Additionally, to satisfy the ECR condition for microwave ECR systems operated at the commercially available 2.45 GHz, a magnetic field of 875 gauss is necessary, requiring large electromagnets, large power, and cooling requirements.

Microwave and microwave ECR systems are not readily scalable. Hardware is available for 2.45 GHz, because this frequency is used for microwave ovens. 915 MHz systems are also available, although at higher cost. Hardware is not readily or economically available for other frequencies. As a consequence, to scale a 12 - 15 cm (5-6 in.) microwave system upward to accommodate larger semiconductor wafers requires the use of higher modes of operation. This scaling at a fixed frequency by operating at higher modes requires very stringent process controls to avoid so-called mode flipping to higher or lower order loads and resulting process changes. Alternatively, scaling can be accomplished, for example, for a 12-15 cm (5-6-in.) microwave cavity, by using a diverging magnetic field to spread out the plasma flux over a larger area. However, this method reduces effective power density and thus plasma density.

The present invention aims at the forementioned drawbacks of prior art processes and systems. The invention therefore provides a system for processing a workpiece according to independent claims 1 and 22.

Further advantageous features, aspects and details of the invention are evident from the dependent claims, the description, the examples and the drawings. The claims are intended to be understood as a first non-limiting approach of defining the invention in general terms.

The invention thus refers to RF plasma processing reactors and, more particularly, to an inventive plasma reactor which uses high frequency (HF) and low frequency (LF) energy sources and associated electrodes for coupling the HF and LF energy to the plasma.

The invention provides a plasma reactor using UHF/VHF and RF triode source.

In one aspect, the invention which satisfies the above and other criteria is embodied in a system for processing a workpiece in an enclosure defining a vacuum processing chamber by introducing process gas into the chamber and generating a plasma from the gas, comprising: electrode means for coupling AC electrical energy into the chamber to generate a plasma in the gas; and means for applying high frequency VHF/UHF electrical energy to the electrode means for controlling the density of the plasma and the plasma ion density.

In addition, the invention encompasses an embodiment wherein the electrode means is adapted for applying relatively lower frequency AC electrical energy to the electrode means for controlling the sheath voltage associated with the electrode means and plasma ion energy. Preferably, the frequency of the high frequency AC energy is within the range of about 50 MHz to about 800 MHz, and that of the relatively lower frequency AC energy is within the range of about 0.1 MHz to about 50 MHz.

In another aspect, the electrode means comprises two electrode structures for applying plasma generating AC electrical energy to the chamber, the means for applying the high frequency AC electrical energy is connected to one of the electrode structures and the means for applying the relatively lower frequency AC electrical energy is connected to the other of the two electrode structures.

In yet another aspect, the enclosure includes a dielectric window in one surface thereof; the electrode means includes a wafer support electrode within the chamber and a plate electrode on the dielectric window; the means for applying the relatively low frequency AC energy is connected to the wafer support electrode; the means for applying high frequency AC energy is connected to the chamber enclosure; the plate electrode is at system ground; and both means for applying AC electrical energy are referenced to the plate electrode as ground, such that the electrodes form an electric field in the chamber between the wafer support electrode and the plate electrode.

In an alternative embodiment, the electrode means is a single electrode structure located within the chamber and adapted for supporting a workpiece, and both means for applying AC electrical energy to the electrode means are connected to the single electrode structure.

In another alternative embodiment, the enclosure includes a dielectric window in one surface thereof; the electrode means includes a wafer support electrode within the chamber and a plate electrode on the dielectric window; the means for applying high frequency AC electrical energy is connected to the plate electrode; the means for applying the relatively low frequency AC energy is connected to the wafer support electrode; and both means for applying AC energy are referenced to the chamber enclosure as ground, such that the electrodes form an electric field in the chamber between the wafer support electrode and the plate electrode.

In a presently preferred embodiment, the electrode means includes an electrode located within the chamber and adapted for supporting a workpiece thereon and an electrode structure surrounding the periphery of the plasma chamber; the means for applying high frequency AC energy is connected to the peripheral electrode structure; and the means for applying relatively lower frequency AC energy is connected to the wafer support electrode. Preferably, the enclosure includes a dielectric dome internally defining a section of the chamber; the peripheral electrode structure surrounds the chamber section defined within the dome; the peripheral electrode structure and the wafer support electrode are positioned for forming an electric field in the chamber parallel to the wafer support electrode; and the surrounding electrode structure comprises separate sections and, in combination with the means for applying the high frequency AC electrical energy, provides a differentially driven, ungrounded, balanced drive arrangement for the electrode structure.

In still additional embodiments, the enclosure/chamber includes an integral transmission line structure adapted to apply AC electrical energy of selected frequency from the external source to the plasma chamber, comprising: the wafer support electrode; an outer conductor surrounding the wafer support electrode; and an insulator between the wafer support electrode and the outer conductor such that AC energy applied to the transmission line structure is coupled along the wafer support electrode for controlling the cathode sheath voltage. Also, the high frequency AC electrical energy can be coupled to the electrode means via a matching network. In addition, a biased grid can be incorporated for extracting a stream of charged ions or electrons from the plasma, and a neutralization grid can be located spaced from the extraction grid for extracting a stream of excited neutrals and free radicals.

Other, preferred aspects include a reflector positioned surrounding the electrode means, for preventing radiation of the AC energy into free space.

Magnetic enhancement may be supplied by peripheral permanent or electromagnet arrangements which apply a controlled static magnetic field orthogonal to the plane of the electric field of the surrounding electrode, selected from uniform, diverging and magnetic mirror configurations, for controlling the location of and the transport of the plasma downstream relative to the wafer. Also, magnets may be mounted around the chamber for applying a multipolar cusp field to the chamber in the vicinity of the wafer for confining the plasma to the wafer region while substantially eliminating the magnetic field across the wafer. In addition, a magnetic shunt may be positioned surrounding the wafer and the wafer support electrode for diverting any magnetic field from the wafer support electrode.

The system construction permits scaling of its size by selecting the frequency of operation.

Another aspect relates to the construction and operation of a plasma processing reactor, comprising: a housing including a dielectric dome defining a plasma chamber therein; electrode means within the plasma chamber for supporting a semiconductor wafer; a gas inlet manifold in the housing for supplying reactant gas to the plasma chamber; vacuum pumping means communicating with the plasma chamber for maintaining a vacuum therein; and a high frequency energy source comprising a split electrode surrounding the dome for capacitively coupling high frequency energy of controlled power into the plasma chamber for generating a plasma therein of controlled density and controlled ion flux density. As mentioned, this system may incorporate various preferred and alternative features, including, preferably, an energy source for coupling lower frequency energy of controlled power into the chamber for controlling the sheath voltage at the wafer support. The bias frequency is selected to control voltage; bias power is selected/varied, to control sheath voltage and ion energy.

Further, a process is described for coupling high frequency energy into a processing chamber within a vacuum enclosure, preferably via a split electrode surrounding a dielectric dome portion of the enclosure, for generating a plasma within the chamber to effect fabrication of materials selected from etching of materials, deposition of materials, simultaneous etching and deposition of materials and/or sequential etching and deposition of materials. Alternatively, the high frequency power is applied via a plate electrode formed on a dielectric window in the enclosure. The process also involves controlling the high frequency power to control plasma density and ion flux density. Preferably, the object undergoing fabrication is supported on an electrode and relatively lower frequency AC power is applied to the electrode for independently controlling the associated sheath voltage and the ion energy, with respect to plasma density and ion flux density.

Specific process aspects include but are not limited to etching oxide, including etching contact holes in oxide formed over polysilicon (polycrystalline silicon) and etching via holes in oxide formed over aluminum; so-called "light" etching of silicon oxide and polysilicon; high rate isotropic and anisotropic oxide etching; etching polysilicon conductors such as gates; photoresist stripping; anisotropic etching of single crystal silicon; anisotropic photoresist etching; low pressure plasma deposition of nitride and oxynitride; high pressure isotropic conformal deposition of oxide, oxynitride and nitride; etching metals, such as aluminum and titanium, and compounds and alloys thereof; and sputter facet deposition, locally and globally, and with planarization.

The above and other aspects of the invention are described with respect to the drawing in which:

FIG. 1 schematically depicts an RF reactor system in accordance with the present invention;
FIGS. 2, 3 and 4 schematically depict systems incorporating alternative electrode configurations;
FIG. 5 is a block diagram of a presently preferred power control system;
FIG. 6 depicts a representative integrated circuit via hole;
FIG. 7 depicts the via hole of FIG. 6 after application of a widening sequence in accordance with the invention;
FIGS. 8A-8D depict various magnetic enhancement fields;
FIG. 9 is an electrical schematic of a presently preferred matching network for the preferred, differentially driven, ungrounded, balanced split electrode arrangement of FIG. 1.;
FIG. 10 is a schematic physical equivalent of FIG. 9; and
FIG. 11 is a simplified schematic depiction of a motor control circuit for the network of FIGS. 9 and 10.

Detailed Description of the Preferred Embodiment(s)

1. OVERALL SYSTEM

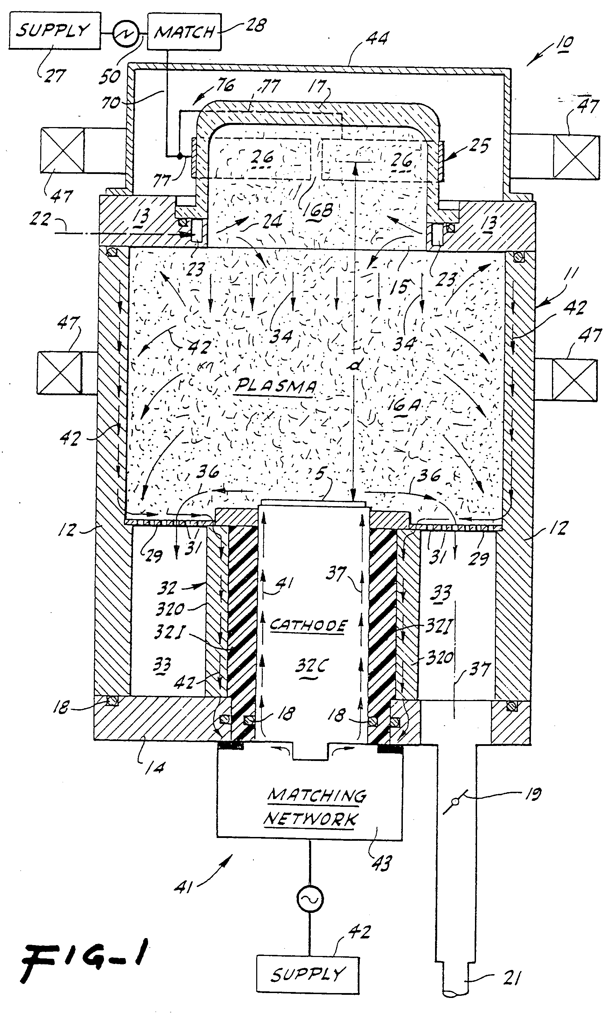

FIG. 1 is a schematic sectional view of a plasma reactor chamber system 10 which uses a plural (two or more) electrode plasma source arrangement, a magnetically-enhanced plasma source arrangement and other aspects of my present invention. The exemplary chamber is a modification of that depicted in European Patent Appl.91112917.9 incorporated by reference, which includes an integral transmission line structure. The salient features of the invention are applicable generally to plasma reactor chambers. Furthermore, it will be understood by those of skill in the art and from the description below that various features of the invention which cooperatively enhance the performance of the reactor system may be used separately or may be selectively omitted from the system. For example, the process conditions provided by the plural (two or more) electrode plasma source arrangement frequently eliminate any need for magnetic enhancement.

The exemplary system 10 includes a vacuum chamber housing or enclosure 11, formed of anodized aluminum or other suitable material, having sidewalls 12 and top and bottom walls 13 and 14. Anodized aluminum is preferred because it suppresses arcing and sputtering. However, other materials such as bare aluminum and process-compatible polymers or quartz or ceramic liners can be used. The chamber can be heated or cooled for process performance. Top wall or ceiling 13 has a central opening 15 between a lower chamber section 16A defined between walls 12-12 and an upper chamber section 16B defined by a dielectric dome 17. The dome preferably is quartz but can be made of several dielectric materials, including alumina and alpha-alumina (sapphire). The dome may be heated or cooled as required for process performance. A fluid or gas heat transfer medium may be used, or heating elements may be used to heat the dome directly. Various vacuum seals 18 such as O-rings are interposed between the various mating surfaces to maintain vacuum-tight enclosure. The interior of the chamber housing 11 (chamber 16) is evacuated via a throttle valve 19 (which regulates pressure independent of flow rate) in a vacuum line 21 which connects to a vacuum pumping system (not shown).

Reactant gases are supplied to the chamber 11, as indicated schematically at 22, typically from one or more sources of pressurized gas via a computer-controlled flow controller (not shown) and enter the internal vacuum processing chamber 16 through ring gas manifold 23, which is mounted on the inside of or integral with, top wall 13. The manifold 23 preferably supplies etching gas and/or deposition gas at a slight upward angle to the chambers/chamber sections 16B and 16A for developing an etching and/or deposition plasma upon application of high frequency RF energy. Gases may be brought in directly via the process chamber instead of, or in addition to, through the manifold. For example, it may be desired to bring an inert gas or other gas into the manifold 23, and bring other reactant gases in via a lower manifold or gas inlet (not shown) in the process chamber below.

The high frequency (HF) energy such as, preferably, VHF/UHF energy of frequency 50 to 800 MHz is applied by a substantially closed, split electrode structure 25 comprising a pair of generally semi-circular band electrodes 26-26, which surround the dome 17 and are powered by a high frequency (HF) source 27, and effect plasma excitation in the chamber 16 by capacitive coupling via the dielectric dome 17. This contrasts with conventional RF system arrangements, in which the RF power is applied between two electrodes, typically the wafer support electrode 32C, the upper surface of which supports wafer 5, and a second electrode which is defined by the sidewalls 12, top wall 13 and/or manifold 23 of the reactor chamber.

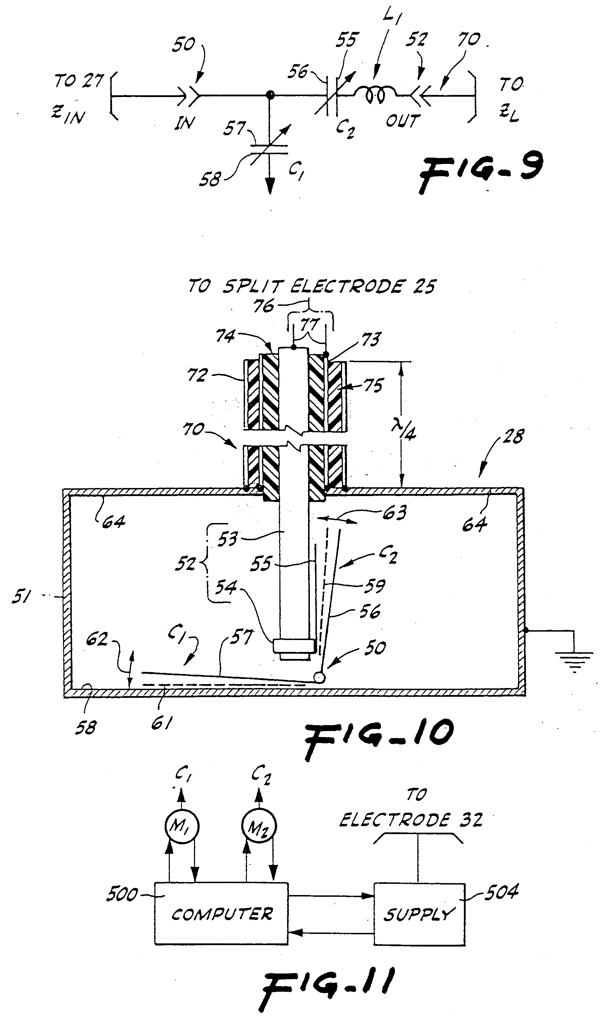

Preferably, the HF AC source 27 is coupled to the electrode 25 by a suitable matching network 28 via a transmission line structure having twin leads 77-77 coupled to the band electrodes 26-26 to provide a differentially driven, balanced, ungrounded drive arrangement. This system is shown in FIGS. 9-11 and described more fully below.

Preferably, the gas flow from the upper chamber section 16B is downward toward the wafer 5 and is then pumped radially outward from the wafer. To this end, an annular vacuum manifold 33 is defined about cathode transmission line structure 32, between chamber wall 12 on one side and the outer transmission line conductor 320 on the other, and between the chamber bottom wall 14 on the bottom and a conductive pumping screen 29 on the top. The manifold screen 29 is interposed between the vacuum manifold 33 and the plasma chamber 16A and provides a conductive electrical path between chamber walls 12 and the outer conductor 320 of the transmission line structure 32. The manifold 33 defines an annular pumping channel for implementing uniform radial pumping of exhaust gases from the periphery of wafer 5. The exhaust manifold 33 communicates into the exhaust gas system line 21 via one or more apertures 31 in the bottom wall 14. The overall gas flow is along path 22 into the inlet manifold 23, along path 24 into the upper (and)lower chamber section, along path 34 from the upper chamber section 16B toward wafer 5, along path 36 radially outwardly from the peripheral edge of the wafer and through screen 29 into the gas outlet manifold 33, and along path 37 from the exhaust manifold 33 to the exhaust system 21.

The split electrode structure 25 is positioned adjacent the dome 17 and the plasma chamber 16B for coupling the relatively high frequency (HF) energy into the chamber and forming a changing electric field between the two band electrodes in a generally right cylinder volume therein parallel to the top surface of the wafer support electrode 32C and the wafer 5 thereon. The changing electrical fields energize the process gas and thus form a plasma in chamber 16 (numeral 16 collectively designates the chamber 16A and 16B and the plasma therein) characterized by relatively high density and low energy ions. The plasma is generated in the dome concentrated in the above-mentioned right cylindrical volume defined by the electrode 25 and active species including ions, electrons, free radicals and excited neutrals move downstream toward the wafer by diffusion and by bulk flow due to the prevailing gas flow described herein. Also, an appropriate magnetic field can be used to extract ions and electrons toward the wafer as described below. Optionally, but preferably, a bias energy input arrangement 41 comprising a source 42 and a bias matching network 43 couples relatively low frequency (LF) RF energy to the wafer support electrode 32C for selectively increasing the plasma sheath voltage at the wafer and thus selectively increasing the ion energy at the wafer. Preferably, the LF energy is within the range of about 0.1 MHz to about 50 MHz.

A reflector 44 which essentially is an open-bottom box encloses the electrode at the top and sides but not at the bottom. The reflector prevents radiation of the HF energy into free space and thereby concentrates the radiation and dissipation of the power in the plasma to enhance efficiency.

As described in greater detail below, optionally, one or more electromagnets 47-47 or permanent magnets are mounted adjacent the chamber enclosure 11 for providing a static shaped-magnetic field for enhancing the density of the plasma at the wafer 5.

In short, the invention uses relatively high frequency electrical energy, typically 50 MHz to 800 MHz (high frequency relative to the optional bias energy but typically much lower than microwave or microwave-ecr frequencies), to produce directed, generally horizontal fields inside a vacuum chamber for generating a plasma characterized by high density and relatively low energy, without-coupling potentially damaging HF energy through the wafer 5. In the preferred downstream plasma source arrangement illustrated in FIG. 1, the energy is fully absorbed remote from the wafer, with high plasma density, ensuring that the energy does not propagate to the wafer and thus minimizing the probability of damage. Selectively, and optionally relatively low frequency (LF) auxiliary AC bias energy is applied to the wafer support electrode 32C for increasing the wafer sheath voltage and, thus, the ion energy as required. The (1) HF energy and (2) LF energy independently control (1) plasma density and ion density and (2) sheath voltage and ion energy.

The frequency of the system may be varied within the range 50 to 800 MHz to permit scaling the diameter of chamber 16B over the range 81 to 5 cm (32 to 2 in.) In particular, the system can be scaled upward to accommodate the increasingly large diameter wafers favored by the semiconductor industry, without changing the electromagnetic mode, by the simple expedient of decreasing the frequency within the described range and retaining low mode operation, thus avoiding the possibility of mode flipping and process changes which are associated with increasing the mode of operation.

Because the high frequency of the source 27 driving the electrode structure 25 is nonetheless much lower than the frequencies used in microwave or microwave-ECR applications, the optional smaller magnets operated at lower DC current by less expensive power supplies can be used, with associated smaller heat loads. In addition, as is obvious from the above discussion, a twin lead transmission line can be used instead of wave guides. In addition, the plasma non-uniformities caused by the $\mathbf{E} \times \mathbf{B}$ electron drift in other magnetic-enhanced or assisted systems are absent here, because the applied magnetic fields (both the magnetic component of the HF field applied via the electrode 25 and any static axial magnetic field applied by magnets 47), are substantially parallel to the electric field at the cathode 32C. Thus, there is no $\mathbf{E} \times \mathbf{B}$ drift in the system.

A magnetic shunt path formed with a high permeability material may be used to allow a $\mathbf{B}$ field in the source (upper chamber 16A) but not at the wafer.

Optionally, permanent or electromagnets can be placed in a multi-polar arrangement around the lower chamber 16A, typically in an alternating pole north-south-north-south...north-south arrangement, to generate a multi-cusp magnetic mirror at the chamber walls. The magnets may be vertical bar magnets or preferably horizontal ring magnets, for example. Such magnets may be used to reduce electron losses to the walls, thus enhancing plasma density, without subjecting the wafer to magnetic fields.

## 2. MAGNETIC ENHANCEMENT

As mentioned above, one or more (preferably, at least two) permanent or electromagnets 47-47 define a static, generally axial magnetic field orthogonal to and through the plane of the of the $\mathbf{E}$ field of the electrode 25. Preferably, one of three field-types is used: uniform, divergent or magnetic mirror.

Referring to FIG. 8A, a homogeneous, axial uniform magnetic field 81 applied orthogonally to the wafer 5 restricts the motion of the electrons to the walls. Because of the inability of ions to follow high frequency field variations, the ions follow the electron deficiency, and are concentrated in the plasma over the wafer. For maximum efficiency, this and other static magnetic fields can be tuned to resonance with the high frequency electromagnetic field: omega = 2 pi F = Be/m , where B is the magnetic flux density and e and m are the electron charge and mass, respectively.

An axially divergent field 82 is depicted schematically in FIG. 8B. By the conservation of magnetic moment, the axial gradient of the magnetic field converts circular translational energy to axial translational energy and tends to drive the electrons and ions from the stronger field regions to the weaker regions thereof. Diverging magnetic fields can be used to push the electrons and ions from the plasma generating regions and to concentrate the plasma at the wafer.

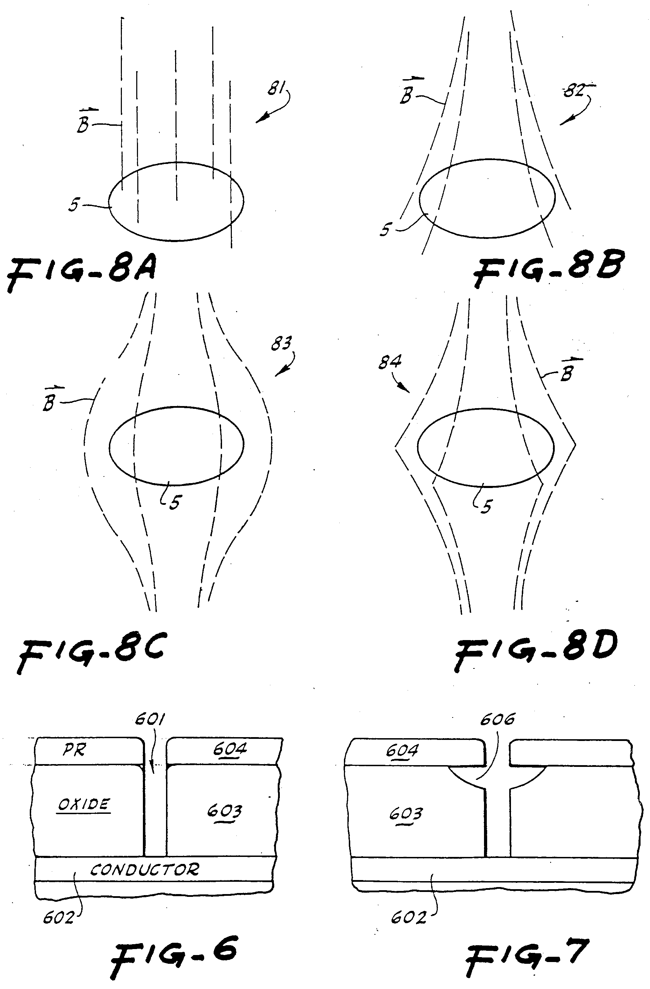

Referring to FIGS. 8C and 8D, there are shown, respectively, a bulging or aiding magnetic field 83 (FIG. 8C) and a cusp-shaped or opposing field 84 (FIG. 8D). The effect of each of these so-called "magnetic mirror" fields is similar to that of the axially divergent field: charged particles are driven from the relatively strong field regions (at the ends here) toward the relatively weak central region.

Selectively positioning the magnet(s) and selecting and varying the strength of the fields provided by the single magnet or cooperating magnets shapes the associated uniform, diverging, or magnetic mirror field in controlled fashion to increase the density of the plasma at the wafer. For magnetic mirror fields, the preferred wafer position for maximum plasma density enhancement is closely adjacent to or at the bulge or cusp, to provide maximum plasma density enhancement.

It may be desired to utilize an axial magnetic field at the plane of the electrode 25 to enhance plasma generation, but to eliminate the magnetic field at the wafer 5. An annular disk of high magnetic permeability materials (such as nickel or steel for soft iron) may be interposed below the magnet(s) and plane of the electrode 25 but above the wafer 5. Optionally, multipolar confinement may be used in the lower chamber region by defining ring or bar magnets in an alternating pole arrangement.

### 3. Split Electrode Matching Network 28

To implement the split electrode embodiment depicted in FIG. 1 a matching network is required to match the plasma load impedance presented to the split electrode 25 and to the generator 27. In addition, it is desired to drive the split electrode 25 differentially, in an ungrounded, balanced (with respect to ground) fashion. Driving the electrodes in this manner produces the most uniform plasma, and minimum particle energy.

The preferred matching network 28 is a modified embodiment of the matching network described in above-mentioned co-pending, commonly assigned European patent application 91112917.9, the disclosure of which application is incorporated by reference. Referring to FIGS. 9 and 10, in addition to FIG. 1, the presently preferred matching network 28 is an L-network comprising a shunt capacitor $C_1$ coupled from the input of the matching network to ground and a series capacitor $C_2$ coupled from the input of the matching network to the output of the matching network, which ties directly to the output transmission line section 70.

It should be noted that the matching network configuration depicted in FIGS. 9 and 10 applies for a typical source output resistive impedance of 50 ohms and the typical plasma 16 resistive impedance component of 1 to 50 ohms and, more generally, when the source output resistance component is greater than the load resistance component. Were the resistive part of the plasma load impedance $Z_1$ to exceed the output resistive impedance of the source, the input and the output connections for the matching network would be reversed.

Capacitors $C_1$ and $C_2$ are air capacitors which comprise fixed and movable conductor plates, typically formed of copper or silver plated cooper sheets. The fixed plate 58 of capacitor $C_1$ is the case or housing 51 of the matching network 28, which is connected to ground. Referring also to FIG. 11, plate 57 is connected to the input 50 from the power supply 27 and is movable along path 62 by motor $M_1$ under the control of the system controller 500, based upon the real time $Z_{in}$ or reflected power. This input is used in controlling the plate separation and, thus, the capacitance of the capacitors in a well-known manner. A sheet 61 of Teflon™ or other suitable low loss, high dielectric strength material is interposed between the capacitor plates 57 and 58 to prevent arcing. Please note, as indicated schematically in FIG. 11, the computer 500 (or a separate computer) is conveniently used to control the operation of the power supply 27 and to select a proper frequency within the range of interest and thereby select the desired voltage and power combination for a given process.

Similarly-constructed series capacitor $C_2$ comprises an insulative, anti-arcing sheet 59 of material such as Teflon™, a leg 56 which is connected to the input 50 and is movable by motor $M_2$, in the manner of capacitor $C_1$, along path 63 to vary the capacitance of $C_2$. A fixed leg 55 is connected to the matching network's output 52, which illustratively comprises a clip 54 which engages the downward-extending conductor post or conductor 53. The conductor 53 is also part of the balun output section 70. Post 53 is extended to add inductance as indicated at $L_1$, of FIG. 9.

The balun 70 converts the grounded match output to a balanced, differential ungrounded output. A 1:1 balun is used. The tri-axial, electrically quarter wave output section 70 comprised of center conductor (post) 53, outer conductor 73, shield 72 and dielectric 74 and 75 is used to isolate the split electrode 25 from ground by presenting a high impedance to any ground current. Balun 70 is terminated via split conductor 76, specifically the two leads 77-77 thereof, which connect to the individual conductors 26-26 of the split electrode 25.

### 4. TRANSMISSION LINE STRUCTURE 32

As described in detail in the incorporated European patent application, 91112917.9, proper co-axial/transmission line design requires both a feed via a low characteristic impedance, short transmission line from the matching network to the wafer and a return path along the transmission line. This design requirement is satisfied by the integral transmission line structure 32 depicted in FIG. 1 which comprises the cathode 32C, concentric annular conductor 320, and a non-porous low loss insulator 32I which surrounds the cathode 32C and insulates the cathode from the concentric annular conductor 32O and displaces process gases which otherwise might break down. For example, Teflon™ or quartz materials are preferred because they have high dielectric strength, low dielectric constant and low loss. The input side of this structure is connected to the matching network in a manner described below. The insulated cathode 32C and outer conductor 32O provide separate current paths between the matching network 43 and the plasma 16. One reversible current path 41 is from the matching network along the outer periphery of the cathode 32C to the plasma sheath at the chamber (electrode) surface. The second reversible path 42 is from the plasma 16 along the upper inside section of chamber walls 12 then along the conductive exhaust manifold screen 29 and via the inside of the outer conductor 32O to the matching network. Please note, the exhaust manifold screen 29 is part of the uniform radial gas pumping system, and the return path for the RF current.

During application of alternating current energy, the RF current path alternates between the directions shown and the reverse directions. Due to the co-axial cable type of construction of the transmission line structure 32 and, more specifically, due to the higher internal impedance of the cathode 32C (relative to the outside thereof) and the higher impedance toward the outer surface of the conductor 32O (relative to the inner surface thereof), the RF current is forced to the outer

In short, the load impedance $Z_1$ will be mismatched with losses, but losses are minimum when $Z_1 \sim Z_0$.

To diminish the losses due to the load mismatch, the co-axial-type transmission line structure 32 is designed to have a characteristic impedance $Z_0$ that is best suited to the range of load impedances associated with the plasma operation. Typically, for the above-described operating parameters (example: wafer support electrode or bias frequency range approximately 5-50 MHz) and materials of interest, the series equivalent RC load impedance, $Z_1$, presented by the plasma to the transmission line will comprise a resistance within the approximate range 1 ohm to 30 ohms and a capacitance within the approximate range 50 pico farads to perhaps 400 pico farads. Consequently, as the optimum, a transmission line characteristic impedance $Z_0$ is selected which is centered within the load impedance range, i.e., is approximately 10 to 50 ohms.

It is necessary that the transmission line 32 be very short in order to avoid transformation of the plasma impedance that the matching network sees. Preferably, the transmission line is much less than a quarter wavelength, lambda/4, and, more preferably, is about (0.05 to 0.1) lambda. More generally, if it is not possible to locate the matching network at a distance much less than a quarter wavelength to the load, advantage is taken of the half wavelength periodicity associated with the impedance transformation by using a transmission line length equal to an integral multiple n = 1, 2, 3, etc., of a half wavelength (lambda/2; lambda; 3lambda/2; etc.). More precisely, the preferred values are lambda/2 to (lambda/2 + 0.05 lambda); lambda to (lambda + 0.05 lambda); 3lambda/2 to (3lambda/2 + 0.05 lambda); etc.). Under such conditions, the matching network should not be located at odd integrals of quarter wavelengths (lambda/4, 3lambda/4, 5lambda/4), because a quarter wave section (or n lambda/4 where n is odd) transforms $Z_1$ such that $Z_{in} = Z_0{}^2/Z_1$, where $Z_1$ is typically small, producing a very large $Z_{IN}$. The matching network then could not match to the plasma load and it would be very difficult to couple power to the plasma without unacceptable system resonance and power dissipation.

Also, for efficient coupling of power, the inside diameter (cross-section dimension) of the return conductor 32O should not be significantly larger than the outside diameter (cross-section dimension) of the center conductor 32C.

In short, the chamber optionally but preferably incorporates a transmission line structure that couples power from the matching network 43 to the plasma 16. That transmission line structure (1) preferably is very short compared to a quarter wavelength at the frequencies of interest or, alternatively, is approximately equal to an integral half wavelength, to prevent undesirable transformation of the plasma impedance; (2) has a characteristic $Z_0$ selected to suppress losses due to the presence of standing waves on the line between the plasma and the matching network; and (3) uses an outside conductor path cross-sectional dimension which is not substantially larger than that of the center conductor.

## 5. CONTROL SYSTEM

The following descriptions are used here in reference to the control system depicted in FIG. 5:

Psp:      Power set point
$P_f$:      Forward power Measured by directional coupler located at /inside power supply
$P_r$:      Reflected power " "
|Z|:      Magnitude of impedance
<phi:      Phase of impedance
Tsp:      Tune set point
Lsp:      Load set point
Tfb:      Tune feedback (measured)
Lfb:      Load feedback (measured)

FIG. 5 is a block diagram of an exemplary system for controlling the various components including the power supplies. Here, a system controller 500 is interfaced to surrounding ( or split or top) electrode power supply 27, impedance bridge 502, matching network 28, electrode 25, bias power supply 504, impedance bridge 505, matching network 43, and cathode 32C. The process parameters top electrode power and DC bias, selected for ion flux density and ion energy, are supplied as input to the controller 500. Controller 500 may also control other parameters such as gas flow(s), chamber pressure, electrode or wafer temperature, chamber temperature, and others. The controller 500 may preset initial $tune_1$ and $load_1$ conditions by issuing signals on $Tsp_1$ and $Lsp_1$ lines connected to matching network 28. The controller 500 may also preset initial $tune_2$ and $load_2$ conditions by issuing signals on $Tsp_2$ and $Lsp_2$ lines connected to the matching network 43. Typically, these conditions are selected to optimize plasma initiation (gas breakdown). Power may be applied first to either the electrode 25 or to the cathode 32, or it may be applied simultaneously to both. The controller issues power set points on $Psp_1$ line to power supply 27 and on $Psp_2$ line to bias power supply 504 simultaneously or sequentially (in either order).

Avalanche breakdown occurs rapidly in the gas, generating a plasma. Controller 500 monitors forward power ($P_{f1}$) and reflected power ($P_{r1}$) to/from the electrode 25, and monitors forward power ($P_{f2}$) and reflected power ($P_{r2}$) to/from the cathode 32. DC bias (cathode to anode DC voltage) is also monitored as shown by controller 500. Controller 500 adjusts the electrode $tune_1$ and $load_1$ parameters by issuing set points on lines $Tsp_1$ and $Lsp_1$, based on either (a) forward power $P_{f1}$ and reflected power $P_{r1}$, or (b) impedance magnitude $|Z_1|$ and impedance phase $<phi_1$. Bridge 502 furnishes impedance magnitude and phase angle information to the controller. The electrode 25 is matched when reflected power $P_{r1}$ is substantially zero and when the impedance (magnitude and phase $|Z_1|<phi$) is the complex conjugate of the top electrode power supply output impedance. (The zero reflected power condition and the conjugate impedance condition occur simultaneously, so either reflected power may be minimized or impedances may be matched, with the same result. Alternatively, VSWR (voltage standing wave ratio) or reflection coefficient may be minimized. Controller 500 adjusts the cathode 32 and the matching network 43 $tune_2$ and $load_2$ parameters by issuing set points on the $Tsp_2$ and $Lsp_2$ lines, based on either (a) forward power $P_{f2}$ and reflected power $P_{r2}$ or (b) impedance magnitude $|Z_2|$ and impedance phase $<phi_2$. Bridge 505 furnishes impedance magnitude $|Z_2|$ and phase $<phi_2$ information to the controller 500. Matching occurs when, similarly to electrode matching, reflected power $P_{r2}$ is essentially zero, and when impedance (magnitude and phase $|Z_2|<phi_2$) is the complex conjugate of the bias power supply 504 output impedance. DC bias is monitored by controller 500, which varies the bias power supply's output power to obtain the desired measured DC bias. Controller 500 subtracts the measured value of DC bias from the desired value of DC bias. If the difference is negative, bias power supply 504 output is increased. If the difference is positive, bias power supply 504 output is decreased (higher bias power supply 504 output generates a more negative DC bias). Proportional, proportional-integral, or proportional-integral-derivative control or other control may be used in accordance with this method.

Alternatively, instead of the preferred embodiment of adjusting bias power supply 504 output to maintain a constant DC bias, a constant bias power supply 504 output may be used.

Controller 500 may be a central controller, or a distributed system of controllers.


6. OTHER FEATURES


A preferred feature of the invention is to automatically vary "bottom" or support electrode bias power to maintain a constant cathode (wafer) sheath voltage. At low pressures ($<6.5*10^{-4}$ bar (500 mt) in a highly asymmetric system, the DC bias measured at the cathode is a close approximation to the cathode sheath voltage. Bottom power can be automatically varied as described in the previous section to maintain a constant DC bias and, thus, to maintain constant sheath voltage. Alternatively, bottom power can be used to selectively vary DC bias and sheath voltage. Bottom power has very little effect on plasma density and ion current density. Top electrode power has very strong effect on plasma density and on current density, but very small effect on cathode sheath voltage. Therefore, it is desired to use top power to define plasma and ion current densities, and bottom power to define cathode sheath voltage.

Features which may be incorporated in the reactor chamber system 10 include, but are not limited to, the use of a fluid heat transfer medium to maintain the internal and/or external temperature of the gas inlet manifold 23 above or below a certain value or within a certain range; the use of fluid heat transfer medium to heat or cool the cathode 32C; the use of fluid heat transfer medium to heat or cool chamber walls 12 or top 13; resistive heating of the cathode 32C; the use of a gas heat transfer medium between the wafer 5 and the cathode 32C; and mechanical or electrostatic means for clamping the wafer 5 to the cathode 32C.

Features are disclosed in Patent 4,872,947, issued October 10, 1989, U.S. Patent No. 4,842,683, issued June 27, 1989, which are incorporated by reference.

The inventive plasma reactor system is depicted in FIG. 1 in the conventional orientation, that is vertically, with the substrate 5 residing on an electrode 32 (cathode) and an electrode 25 located above the electrode. For convenience, we sometimes refer here to the power supplied to the electrode 25 as "top" power and that supplied to the electrode/cathode 32 as "bias" or "bottom" power. These representations and designations are far convenience only, and it is to be understood that the described system may be inverted, that is, configured with the electrode 32 on top and the electrode 25 located below this electrode 32, or may be oriented in other ways, such as horizontally, without modification. In short, the reactor system works independently of orientation. In the inverted configuration, plasma may be generated at the electrode 25 and transported upwardly to the substrate 5 located above the electrode 25 in the same manner as described in the specifications. That is, transport of active species occurs by diffusion and bulk flow, or optionally assisted by a magnetic field having an axial gradient. This process does not depend on gravitational forces and thus is relatively unaffected by orientation. The inverted orientation may be useful, for example, to minimize the probability of particles formed in the plasma generation region in the gas phase or on a surface, falling to the substrate. Gravity then reduces the probability of all but the smallest of such particles moving upward against a gravitational potential gradient to the substrate surface.

The chamber design is useful for both high and low pressure operation. The spacing, d, between the wafer support cathode 32C and the plane of the electrode 25 may be tailored for both high and low pressure operation. For example, high pressure operation at $6.5 * 10^{-4}$ bar to 66.5 mbar (500 millitorr-50 torr) preferably uses spacing d $\leq$ about 5 centimeters, while for lower pressure operation over the range $< 1.3 * 10^{-7}$ bar-$6.5* 10^{-4}$ bar (0.1 millitorr-500 millitorr), a spacing d $>$ 5 centimeters may be preferable. The chamber may incorporate a fixed spacing d, as shown, or may utilize variable spacing designs such as interchangeable or telescoping upper chamber sections. The reactor system 10 is useful for processes such as high and low pressure deposition of materials such as silicon oxide and silicon nitride; low pressure anisotropic reactive ion etching of materials such as silicon dioxide, silicon nitride, silicon, polysilicon and aluminum; high pressure plasma etching of such materials; and CVD faceting involving simultaneous deposition and etchback of such materials, including planarization of wafer topography. These and other processes for which reactor system 10 may be used are described in commonly assigned European patent application 91112905.4 which is incorporated by reference.

### 6. Alternative Electrode Configurations

FIG. 2 schematically depicts an alternative system 120 which is similar to the system 10, FIG. 1, except that a flat dielectric window 17P, instead of the dome 17, is formed in the top of the enclosure, and a flat high frequency electrode 25P (preferably formed on top of the window 17P) is used in place of the circular electrode 25. The FIG. 2 arrangement operates similarly to that of FIG. 1, except that the electric field is not so confined and is perpendicular to the plane of the wafer 5. As a result, the system 120 does not provide the damage suppression characteristics of system 10 (that is, does not suppress wafer damage to the same extent as system 10).

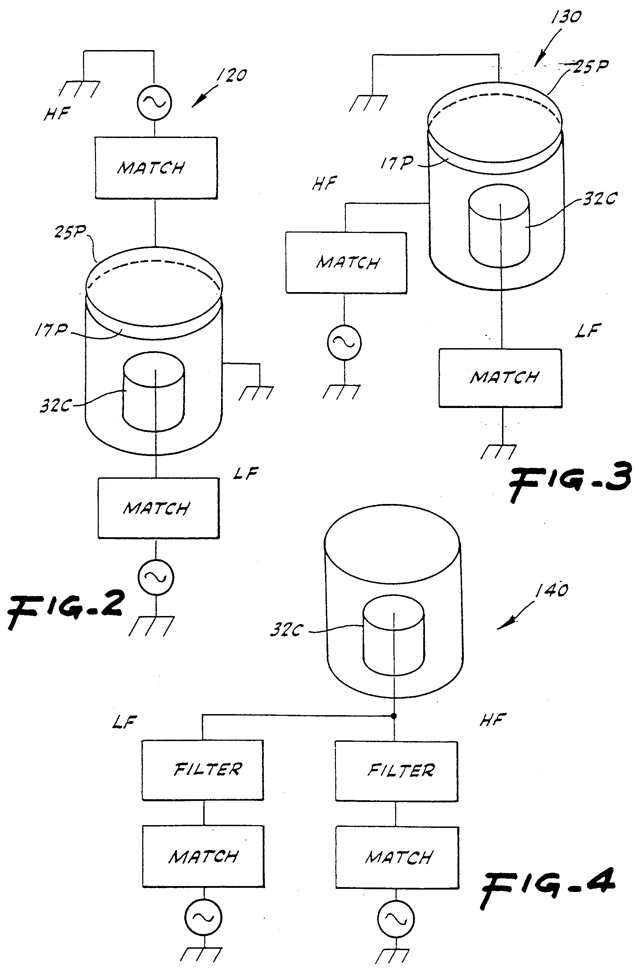

FIG. 3 depicts a system 130 which is the converse or reverse of system 120 in that the top electrode 25P is connected to the chamber wall and the enclosure is connected to the low frequency power.

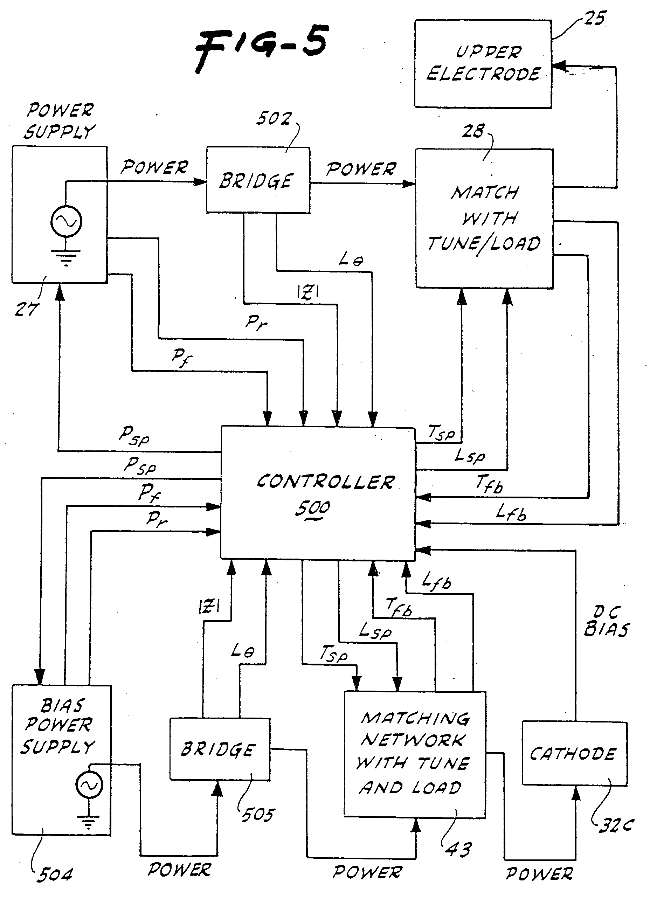

FIG. 4 depicts a system 140 which does not use a top electrode. Instead, both the low frequency and the high frequency sources are connected to the wafer support electrode 32. The differences occasioned by this mixed frequency arrangement relative to system 10, FIG. 1 are, first, HF and LF power are used to control density and energy, respectively, using a single electrode, and, second, this arrangement does not provide the damage suppression characteristics of system 10 (that is, does not suppress damage to the extent of system 10).

The matching network 28 described above is preferred for satisfying the requirements imposed by the high frequency, differential drive, ungrounded, balanced split electrode arrangement. Also, the transmission line structure 32 and associated matching network 43 are preferred approaches. More generally, conventional transmission line structures and match networks can be used, in particular for the low frequency connections.

### 7. APPARATUS EXAMPLES

A present working embodiment of the system incorporates the domed configuration and the split electrode configuration depicted in FIG. 1. The short quartz bell jar chamber 17 has a diameter of 25 cm (10 in). The 26 cm (10.2 in) diameter, 5 cm (2 in) height electrode 25 is ungrounded and surrounds the domed processing chamber 16A. Reflector box 44 is of aluminum. Operation using high frequency RF energy of 1 kilowatt, 200 MHz provides a plasma which extends about 10 cm (4 in) downstream (i.e. below) the top electrode to the wafer. This provides a plasma density of 1-2 x $10^{12}$/cm$^3$ and ion saturation current density of 10-15 mA/cm$^2$ downstream at the wafer. A low frequency auxiliary bias of 13.56 MHz, 200 watts applied to a 12.7 cm (5 inch) wafer positioned on the support electrode approximately 10 cm (4 inches) below (downstream) of the top electrode provides a 200 volt cathode sheath voltage.

### 8. PROCESS EXAMPLES

The above-described reactor embodying my present invention is uniquely useful for numerous plasma processes such as reactive ion etching (RIE), high pressure plasma etching, low pressure chemical vapor deposition (CVD) including sputter facet deposition and planarization, and high pressure conformal isotropic CVD. Other applications include, but are not limited to, sputter etching, ion beam etching, or as an electron, ion or active neutral plasma source.

RIE and low pressure CVD typically use pressures of up to 6.5 * 10⁻⁴ bar (500 mt). High pressure plasma etch and high pressure conformal isotropic CVD processes may be carried out at pressures from about 6.5 * 10⁻⁴ bar to about 66.5 mbar (500 mt to about 50, torr).

(a) Reactive Ion Etching (RIE)

In accordance with the invention, silicon oxide, silicon (single crystal silicon), polysilicon (polycrystalline silicon), aluminum and other materials can be etched in an RIE mode. For this purpose, the high frequency em (electromagnetic) energy is coupled to the plasma by the top electrode 25. Typically, relatively lower frequency AC energy is applied to the cathode 32 (the wafer support electrode or cathode). The high frequency top electrode power is selected to obtain the desired plasma and ion flux density, and the lower frequency AC bias power is selected to independently control the desired cathode sheath voltage and, thus, the ion energy. Please note, in low pressure applications, that is, those involving pressures within the approximate range 1.3 * 10⁻⁷ bar-6.5* 10⁻⁴ bar (0.1 millitorr-500 millitorr), the cathode or wafer sheath voltage closely approximates the DC bias of the cathode and, as a consequence, bias voltage measurements may be used to monitor the cathode or wafer sheath voltage values.

Typically, the useful high frequency em energy range is 50-800 MHz, the preferred useful range 50-400 MHz and the most preferred range 50-250 MHz. Relatively low frequency AC energy (bias energy) ranges are 10 KHz - 50 MHz, 100 KHz - 30 MHz and 5-15 MHz. Unless otherwise specified, the frequency and pressure ranges specified previously in this numbered section apply to the process parameters specified in the RIE tables below. The useful, preferred and most preferred ranges correspond generally to the ranges 1, 2 and 3 in the tables.

RIE Example 1: Silicon Oxide over Polysilicon (Contact Window Hole Etch)

As a first example of the RIE of silicon oxide, consider forming contact window holes through oxide to underlying polysilicon gates. This application is occasioned by a multiplicity of requirements, including no damage to the polysilicon gates or to the underlying gate oxide; no microloading; high oxide/poly selectivity (20/1); vertical oxide etch profile; and high oxide etch rate (typical oxide thicknesses are $\geq$ 1 μm). The high selectivity requires approximately 500 eV ion energy in the etching plasma.

As is known to those of usual skill in the art, suitable gas chemistries for etching contact window holes in oxide comprise fluorine as the main etchant for providing a high etch rate, and may include carbon- and hydrogen-containing gases for enhancing etch selectivity. Specific gases used include $CHF_3$, $CF_4$, $C_2F_6$, $C_4F_8$, $CH_4$, $H_2$, $NF_3$, and $SF_6$. Preferred carbon to fluorine ratios are C/F = 0.1/1 - 2/1 and, when hydrogen is present, the preferred hydrogen to fluorine ratios are H/F = 0.1/1 - 0.5/1 . Argon is a preferred inert gas dopant, because it is relatively massive and inert and, thus, contributes to the sputter etch components of the RIE process, improving the vertical anisotropy.

Using 1 kW, 200 MHz high frequency power ("top" power); 600 watts, 13.56 MHz auxiliary bias ("bottom" or "bias" power): 1.3 * 10⁻⁵ to 3.9 * 10⁻⁵ bar (10-30 millitorr) pressure; the gas chemistry $CHF_3$/argon and gas flow rates 100 sccm/120 sccm provides oxide etch rates of 500 to 700 nm/minute (5000 to 7000 Angstroms/minute) with an oxide-to-poly selectivity of 20/1.

Table 1 summarizes typical contact window etch processes which satisfy the above-described rigid etch requirements.

RIE Example 2: Silicon Oxide over Metal (Via Hole Etch)

As a second example of RIE etching of silicon oxide, consider via hole etching through a silicon oxide layer to an underlying aluminum conductor layer or other metal layer. Here, the critical multiple requirements include no damage to the underlying devices; no damage (i.e., no sputtering) of the underlying aluminum; a vertical oxide etch profile; and a high oxide etch rate. A suitable gas chemistry for these purposes includes fluorine compounds and, typically, carbon. Hydrogen may be used to improve oxide/photoresist etch selectivity. Specific gases used include $CHF_3$, $CF_4$, $C_2F_6$, $C_4F_8$, $CH_4$, $H_2$, $NF_3$, and $SF_6$. Preferred ratios are C/F = 0.1/1 - 2/1 and, when H is present, H/F = 0.1/1 - 0.5/1 . As in the previous oxide example, argon is the preferred inert gas additive, because it is relatively massive and thus contributes to the sputter etch (of the oxide) component of the RIE process, improving the vertical anisotropy of the process. Also, a low cathode sheath voltage, typically $\leq$ 300 volts, is desirable to avoid sputtering the aluminum. Preferably, the voltage is, $\leq$ 200 volts and most preferably about 100-150 volts.

Using top power of 1.5 kVW and 200 MHz; pressure of 1.3 * 10⁻⁵ to 3.9 * 10⁻⁵ bar (10-30 millitorr) reduced bias or bottom power of about 200 watts at 13.56 MHz to provide a 200 volt cathode sheath voltage; and $CHF_3$/$CF_4$/argon gas chemistry at flow rates of 75/75/120 sccm etches vertical-wall via holes at a rate of 400-500 nm/minute (4000-5000 Angstroms/minute) without sputtering of the aluminum. Other chemistries may be used as known by those skilled in the art, such as $CF_4$, $C_2F_6$, $C_4F_6$, $CH_3,F$, $CH_4$ which may be used in various combinations.

Table 2 discloses silicon oxide etch processes which are well suited to etching via holes. The representative cathode bias voltages disclosed in Table 2 provide the desired cathode sheath voltages.

RIE Example 3: Oxide Sputter Etch

Table 3 specifies typical processing parameters for effecting a third type of non-reactive ion etch oxide etch process, oxide sputter. This process is useful for the etchback of deposited films and removal of native oxide on silicon using a relatively non-reactive gas, preferably argon.

RIE Example 4: Selective Polysilicon Etch (Etch Poly Gate Selectively to Oxide)

RIE etching of polysilicon and in particular selective etching of polysilicon with respect to oxides such as underlying oxide layers, requires an etch process characterized by no damage (to interconnects, gates and gate oxides); no microloading; vertical polysilicon etch profile; a high poly/oxide etch selectivity (typically $\geq$ 30/1); and a moderate etch rate (poly thicknesses are 200-500 nm (2000-5000 Angstroms). Referring to Table 4, suitable gas chemistries for achieving these goals include halogen-containing gases compounds. At conventional etch temperatures, > about 0°C, chlorine or bromine chemistry is preferred. Below about - 40°C, fluorine chemistry can be used. Optionally, an inert gas(es) such as argon or helium may be added to the gas chemistry to enhance the vertical etch anisotropy. Other dopant gases such as oxygen may be added to improve the poly/oxide etch selectivity. As is true of the above-described RIE etching of oxide over aluminum, a low cathode sheath voltage (< 200 volts; < 100 volts; 50-100 volts); is preferred to obtain high poly silicon/oxide etch selectivity.

The following process parameters provide a polysilicon gate-forming etch rate of 300-400 nm/minute (3000-4000 Angstroms/minute with a 35/1 selectivity of polysilicon/oxide: 500 watts at 200 MHz top power operated at resonance; bottom power of 100 watts at 13.56 MHz, providing a low cathode sheath voltage of approximately 75 volts; pressure $1.3 * 10^{-5}$ bar to $6.5 * 10^{-5}$ bar (10-50 millitorr) and etching gas chemistry $Cl_2/He/O_2$ (oxygen optional) at flow rates of 80 sccm/400 sccm/(0-4 sccm). Other chlorine sources such as $BCl_3$ may be used.

RIE Example 5: Aluminum Etch

Table 5 depicts the process parameters for RIE etching of aluminum which satisfy the requirements that there be no damage to underlying devices and no corrosion of aluminum and that the process provide a high aluminum etch rate (typically 500-1000 nm/min. (5000-10000 Angstroms/min). Suitable gas chemistries include chlorine- and bromine-containing gases, alone or in combination. Relatively non-reactive/inert gases such as argon may be added for the purpose of profile control. To minimize corrosion of aluminum after etch by chlorinated species, a photoresist strip and Al fluorine passivation can be performed in the same or another chamber.

RIE Example 6: Single Crystal Silicon Etch

Table 6 depicts the representative proven parameters for RIE etching of single crystal silicon in accordance with the process requirements that there be no damage (lattice damage results from high energy bombardment in conventional RF systems) and that the process provide a vertical silicon etch profile, i.e., a high aspect ratio (l/w). The gas chemistry includes halogen species and preferably both bromine and fluorine species (e.g., $HBr + SiF_4$ or $HBr + SiF_4 + NF_3$) for profile control as well as dopants such as helium and oxygen, also for profile control ($HBr/SiF_4/NF_3/O_2/He$).

RIE Example 7: Tungsten Etch

Table 7 discloses the process parameters for RIE etching tungsten without damage to underlying devices. The process is based upon a gas chemistry which comprises a fluorine-containing gas such as $NF_3$ or $SF_6$ and, optionally, inert gas such as argon for the purpose of increasing the sputter etch component.

RIE Example 8: Anisotropic Photoresist Etch

Anisotropic RIE etching of photoresist may be used, for example, for patterning resist for advanced devices. Process requirements are vertical etch profile and no damage to underlying devices. Table 8 discloses the parameters for anisotropic patterning of photoresist using RIE. The associated gas chemistry comprises oxygen and, optionally, fluorine-containing gas such as $CF_4$, $C_2F_6$, $NF_3$ and/or $SF_6$. The wafer is maintained at a low temperature, preferably < 125°C, and most preferably < 75°C, to avoid photoresist reticulation. As discussed previously in the apparatus disclosure, fluid cooling of the wafer support electrode/cathode/pedestal can be used to provide the necessary temperature control.

Anisotropic profiles are etched in photoresist using top power of 1 kW at 200 MHz; pressure of 1.3 * $10^{-5}$ bar to 3.9 * $10^{-5}$ bar (10 - 30 millitorr);

gas chemistry and associated flow rates of 30-100 sccm $O_2$ and 10-50 sccm $CF_4$ (optional); a bottom bias of 0-200 watts at 13.56 MHz; and a cathode temperature of about 60 degrees C. The process provides an anisotropic photoresist etch rate of 0.8-3 $\mu$m/minute

RIE Example 9: Barrier Layer Etching

Barrier layers of material such as titanium, tungsten or titanium nitride are thin layers formed between layers of material such as oxide and aluminum. For example, barrier layers can be used to prevent damage/etching of aluminum during the formation of via holes in overlying oxide layers. The barrier layer must be removed after the oxide via etch and prior to filling the via to permit proper ohmic contact to the aluminum. The critical features of such a barrier layer etch process include no damage to underlying layers or devices, for example, by sputtering the underlying aluminum. Table 9 discloses the process parameters for a halogen-based gas chemistry comprising chlorine-containing and fluorine-containing constituents.

b) Light Etch

A so-called light oxide etching is used after a main oxide etch step, to remove damaged thin layers of material such as oxide or polysilicon, without incurring additional damage. The light etch satisfies the requirements of removing damaged removal without additional damage in part by providing downstream etching (at the wafer support electrode/cathode) using low bombardment energies. Table 10 shows a suitable light oxide etch process which uses fluorine-containing gas chemistry. The light oxide etch process of Table 10 can be changed to a light etch process for polysilicon by substituting a chlorine-containing constituent gas such as $Cl_2$ for the fluorine-containing gas.

In one specific example, top power of 200-1,000 watts at 200 MHz; no bias or bottom power; 1.3 * $10^{-5}$ bar to 6.5 * $10^{-5}$ bar pressure (10-50 millitorr); and 30-120 sccm $CF_4$ provides a low energy oxide etch rate of 10-100 nm/minute (100-1000 Angstroms/minute).

c) High Pressure Plasma Etch

In accordance with my invention, silicon oxide, polysilicon, photoresist and other materials can be etched in a high pressure plasma etch mode. Certain basic features and operation are as described above in the first paragraph under the section 11 heading. Specifically, the high frequency em energy is coupled to the plasma by the substantially closed loop top electrode. Relatively lower frequency AC energy may be applied to the cathode (the wafer support electrode/cathode) as required. The high frequency top power is selected to obtain the desired ion flux density and the lower frequency AC bias power is selected to independently obtain and control the desired cathode sheath voltage and, thus, ion energy.

Profile control is possible during the high pressure etch by selecting the bias power and pressure as follows. At high pressure (1-66.5 mbar (1-50 torr) and low bias power (0-200 W), the process may be isotropic or semi-anisotropic horizontally. By increasing the bias power (200 W - 1,000 W) and/or decreasing the pressure (6.5*$10^{-4}$ bar to 1 mbar) (500 mt-1 torr), the etch process may be semi-anisotropic vertically or anisotropic vertically. In general, increasing/decreasing bias power increases/decreases vertical anisotropy, while decreasing/increasing the pressure increases/decreases vertical anisotropy. Typically, useful top and bias frequencies are, respectively, 50-800 MHz and 10 KHz - 50 MHz, while more preferred useful ranges are 50-400 MHz and 100 KHz - 30 MHz, and presently the most preferred ranges are 50-250 MHz and 5-15 MHz.

High Pressure Plasma Etch: Isotropic Oxide Etch

FIG. 6 depicts the structure which exists after contact or via holes 601 are etched through an oxide layer 603 to underlying conductor 602 using the photoresist pattern definition mask 604. As integrated circuit devices become increasingly small and features such as the via holes 601 become correspondingly narrower, filling the hole becomes increasingly difficult. Referring to FIG. 7, the aluminum fill is made easier by first widening the top of the hole, as indicated at 606, FIG. 7. The widening step requires an etch process that has a horizontal etch component. In addition, it is desirable that this etch step not damage the integrated circuit components. My process described in Table 11 satisfies these requirements and, thus, is ideally suited to the application depicted in FIG. 7 as well as to other applications requiring directional control.

Furthermore, as alluded to above, bias power and pressure may be selected to vary the etch directionality from preferentially horizontal using relatively high pressure (3.9 mbar to 66.5 mbar (3 to 50 torr) with no bias or very low bias, to isotropic at moderate pressure (1.3 to 3.9 mbar (1 to 3 torr) and no to low bias (0-200 W), to preferentially vertical at lower pressure ($6.5 * 10^{-4}$ bar to 1.3 mbar (500 mt-1 torr) and higher bias (200-1000 W). As indicated in Table 11 wafer temperatures are maintained below 125°C for the purpose of preventing photoresist reticulation and the resultant loss of pattern definition.

Using top power of 1-1.5 kW at 200 MHz; pressure of about 1.3 mbar (1 torr) 500 sccm - 2,000 sccm $NF_3$ or $CF_4$; and a cathode temperature of about 60-75 degrees C provides an isotropic silicon oxide etch rate of about 250-450 nm/minute (2500-4500 Angstroms/minute)

Photoresist Strip

Stripping thick photoresist masks requires high photoresist etch rates without damage to associated integrated circuit components and without etch residue. A downstream process is preferred. Table 12 depicts a suitable process which is based upon a gas chemistry comprising oxygen as the main photoresist etchant and, optionally, including nitrogen for the purpose of increasing strip rate and/or preferably fluorine-containing gas for passivation (of aluminum). The wafer temperature is controlled to below 300°C for the purpose of avoiding resist reticulation. In addition, the third example (range 3) in the table effects fluorine passivation.

A fast downstream photoresist strip process uses top power of 1-1.5 kW at 200 MHz; (no bias or bottom power); pressure of about 1.3 mbar (1 torr); etching gas chemistry and flow rates of 800-1,000 sccm $O_2$, 100-200 sccm $N_2$ (optional) and 0-100 sccm $CF_4$ (optional); and a cathode temperature of 100-200 degrees C (the strip rate is temperature dependent) and provides a strip rate of 1-3 µm per minute.

14. CHEMICAL VAPOR DEPOSITION (CVD)

In accordance with the invention, low pressure chemical vapor deposition (LPCVD) may be used to deposit various materials including silicon oxide, boron- and phosphorous-doped oxide (including borosilicate glass (BSG), phosphosilicate glass (PSG) and borophosphosilicate glass (BPSG)) and plasma nitride. The top electrode, bias electrode and pressure ranges for effecting CVD (chemical vapor deposition) are similar to those used for the above-described RIE etching processes. That is, the high frequency em energy coupled to the plasma has a useful frequency range 50-800 MHz, preferred useful range 50-400 MHz, and presently preferred range 50-250 MHz. The relatively lower frequency AC energy is applied when required to the wafer support electrode/cathode using ranges of 10 KHz - 50 MHz, 100 KHz - 30 MHz and 5-15 MHz. The high frequency top power is selected to obtain the desired ion flux density and the lower frequency AC bias power is selected to independently obtain and control the desired cathode sheath voltage and, thus, ion energy. Preferably, pressure is in the range $1.3 * 10^{-7}$ bar-$6.5 * 10^{-4}$ bar (0.1 millitorr-500 millitorr) and, more preferably, $1.3 * 10^{-6}$ bar to $1.3 * 10^{-4}$ bar. (1 to 100 mt).

Also in accordance with the invention, high pressure chemical vapor deposition (HPCVD) may be used to deposit various materials including those discussed in the previous paragraph using the high frequency top energy and the low frequency bias energy described in the preceding paragraph, but typically using pressure > $6.5 * 10^{-4}$ bar (500 millitorr).

In the HPCVD application, the high frequency em energy is coupled to the plasma by the top electrode and the relatively lower frequency AC energy is applied to the wafer support electrode. As mentioned, the high frequency power is selected to obtain the desired plasma density and the lower frequency AC bias power is selected to independently obtain and control the desired cathode sheath voltage and thus ion energy. For HPCVD processes, both radical and ion flux densities are important. The high pressure is used to vary the ratio of the radical deposition component to the ion deposition component. Relatively higher pressure $6.5 * 10^{-6}$ bar to $6.5 * 10^{-5}$ bar (5-50 mt) and lower bias (0 to 2.6 * $10^{-4}$ bar (0-200 mt)) generate more radicals with respect to ions and lower bias yields less ion directionality. Relatively lower pressures of about $6.5 * 10^{-4}$ bar to 6.5 mbar (500 mt to 5 torr) and higher biases generate less radicals with respect to ions, and higher bias of about 200-1,000 W yields more ion directionality. By controlling these parameters, the degree of deposited film conformality can be varied, from slightly preferentially horizontal under conditions of high pressure, no bias; to isotropic using very low bias to no bias, moderate pressure; to preferentially vertically at lower pressure, higher bias. Preferentially horizontal pressure 13 to 65 mbar (10 to 50 torr), no bias; isotropic pressure 6.5 to 13 mbar (5 to 10 torr), bias 0-200 W; and preferentially vertical pressure $6.5 * 10^{-4}$ bar to 6.5 mbar (500 mt - 5 torr), bias 200-1000 W.

(a) Low Pressure CVD

1) Plasma Nitrides and Plasma Oxynitrides

Applications of plasma nitride and plasma oxynitride include as passivation layers and intermetal dielectrics. In such applications, the associated deposition process must not damage devices. When used to form passivation layers, the process must provide good moisture barrier with stress control and when used to deposit an intermetal dielectric, it must provide step coverage, high dielectric strength, controlled physical properties (stress), electrical properties (dielectric strength and dielectric constant), optical properties (absorption spectrum) and chemical properties (hydrogen content). Please note, typically plasma nitride and plasma oxynitride are not stoichiometric, rather, the deposited nitride materials are Si-H-N and the oxynitride materials are Si-H-O-N.

Typically, the gas chemistry comprises silane and nitrogen when low hydrogen content nitride is required, or silane, nitrogen and ammonia where higher hydrogen content can be tolerated, or the same considerations apply to oxynitride except that the gas chemistry includes an oxygen-containing gas such as nitrous oxide or oxygen itself, and typically a lower nitrogen flow rate. The corresponding processes for plasma nitride deposition and for plasma oxynitride deposition are summarized below, respectively, in Tables 13 and 14.

2) LPCVD Oxide

Applications for LPCVD silicon oxide include intermetal dielectrics. Critical process requirements include no damage to underlying devices, gap-filling capability, high rate deposition and control of physical, electrical, optical and chemical properties, as described in greater detail above with respect to LPCVD plasma nitride. Typically, the gas chemistry for the process includes a silicon-containing gas (such as silane or TEOS), an oxygen-containing gas (oxygen itself or nitrous oxide) and, optionally, an inert gas (typically, argon). Additional boron and phosphorous dopants may be used to provide BSG, PSG and BPSG glasses, and arsenic dopant may be added for the purpose of, for example, improving step coverage The relevant process is summarized in Table 15.

One variation on the above LPCVD oxide process is bias sputter deposition, which is a two-step process. First, the process of Table 15 is used, but with no bottom bias, to deposit a thin oxide layer while ensuring that the aluminum is not sputtered. Second, bottom bias and argon flow are added as indicated in Table 15 to effect sputter facet deposition.

In a third variation, silicon oxide planarization may be effected by modifying the bias sputter deposition process so that the ratio of unbiased deposition rate to sputter etch rate is selected to planarize the wafer topography. The sputter etch rate is determined by the bias and pressure while the unbiased deposition rate is determined by the top power and the reactant species. Consequently, the ratio is determined by selecting the four factors, bias power, pressure, top power and reactant flow rates.

In a fourth variation, the silicon oxide planarization can be extended to provide a global or large area planarization process by incorporating materials such as $B_2O_3$ which readily flows during the deposition process and fill large areas between features. For the exemplary $B_2O_3$, the associated gas chemistry is TMB (trimethylborate) and $O_2$ (optional inert gas (He)).

3) CVD Low Pressure (Facet) Deposition

In this process, sometimes known as a CVD facet process, etching of the materials (e.g., oxide or nitride) deposited on the outside (upper) corners of a trench in the silicon wafer is also carried out simultaneously with the deposition of oxide or nitride into the trench to avoid formation of voids in the filler material. In the prior art, such faceting and deposition was carried out simultaneously in ECR/microwave frequency plasma CVD. The prior art use of plasma-assisted CVD at high frequencies, such as 13.56 MHz, resulted in the need for cycling the wafer between a deposition chamber and an etching chamber to achieve the desired faceting.

In accordance with the invention, simultaneous low pressure CVD deposition and faceting may be carried out using a plasma-assisted CVD process wherein the plasma is energized by the top electrode operating in a frequency range of about 50 MHz to 800 MHz and, preferably, in a frequency range of from about 50 MHz up to about 250 MHz. Wafer bias is applied to effect sputter faceting. The use of complicated microwave/ECR equipment, and the need for cycling the wafer between deposition and etching chambers, are avoided.

Additionally, planarization of the wafer topography may be performed by selecting the ratio of unbiased deposition rate to sputter etch rate based on device/feature geometry. It may be combined with deposition of such materials as $B_2O_3$ which flow during the deposition process to globally planarize the wafer.

(b) High Pressure CVD

1) Conformal Isotropic Plasma Nitride And Plasma Oxynitride

Like their LPCVD counterparts, my high pressure CVD, conformal, isotropic plasma nitride and oxynitride processes have application such as to passivation layers and intermetal dielectrics. The requirements and gas chemistries discussed above relative to their LPCVD counterparts apply here as well. In the HPCVD process, bias power is used to control film density and stress. The processes for depositing low hydrogen nitride ($SiH_4 + N_2$) and conventional higher hydrogen plasma nitride (silane + nitride + ammonia) are summarized in Table P.

Table 16 can be used for the deposition of low hydrogen content oxynitride and higher hydrogen content oxynitride by incorporating an oxygen source (oxygen or, preferably, nitrous oxygen) in the gas chemistry. The same $N_2$ flow rates are used for oxynitride and nitride.

2) Conformal Isotropic Silicon Oxide

The applications and associated requirements for this HPCVD process are similar to those for the LPCVD counterpart, with the possible exception that the LPCVD process is more suitable to filling gaps the HPCVD process may be favored for step coverage applications. My present HPCVD process uses a gas chemistry comprising silicon-containing species (typically, silane or TEOS (tetraethylorthosilicate or tetraethyloxysilicate)), an oxygen-containing species (typically, oxygen itself or preferably nitrous oxide) and, optionally, an inert gas (typically, argon). The overall HPCVD process for depositing conformal silicon oxide is summarized in Table 17.

The above examples are representative. Those of usual skill in the art will readily extend the examples to achieve isotropic and anisotropic etching of various materials.

Table 1

| OXIDE CONTACT WINDOW ETCH OXIDE/POLY | | | |
|---|---|---|---|
| Parameter | Range | | |
| | 1 | 2 | 3 |
| Top elect. power (W) | 300-5000 | 500-2500 | 800-2000 |
| Top freq. (MHz) | 50-800 | 50-400 | 50-250 |
| Bias power (W) | 100-1000 | 200-1000 | 400-800 |
| Bias freq. | 10 KHz - 50 MHz | 100 KHz - 30 MHz | 5-15 MHz |
| Press. (mt) | $\leq$ 500 | 1-100 | 5-50 |
| Wafer temp. (°C) | $\leq$ 125 | - | - |
| Gas Chemistry (sccm) | | | |
| Etchant | CF=0.1/1-2/1 | $CHF_3$=30-600 | 50-300 |
| Dopant | HF=0.1/1-0.5/1 | Ar=30-600 | 50-300 |

Table 2

| OXIDE VIA HOLE ETCH OXIDE/ALUMINUM | | | |
|---|---|---|---|
| Parameter | Range | | |
| | 1 | 2 | 3 |
| Top elect. power (W) | 100-5000 | 300-2500 | 800-2000 |
| Top freq. (MHz) | 50-800 | 50-400 | 50-250 |
| Bias power (W) | 100-1000 | 100-500 | 100-300 |
| Bias freq. | 10 KHz -50 MHz | 100 KHz -30 MHz | 5-15 MHz |
| Cathode Sheath (V) | $\leqq 300$ | $\leqq 200$ | 5-50 |
| Press. (mt) | $\leqq 500$ | 1-100 | 5-50 |
| Wafer temp. (°C) | $\leqq 125$ | - | - |
| Gas Chemistry (sccm) | | | |
| Etch | CF=0.1/1-2/1 <br> HF=0.1/1-0.5/1 | $CHF_3$ <br> $CF_4$ <br> Ar | 50-300 <br> 50-300 <br> 50-300 |

Table 3

| OXIDE SPUTTER ETCH | | | |
|---|---|---|---|
| Parameter | Range | | |
| | 1 | 2 | 3 |
| Top elect. power (W) | 300-5000 | 500-2500 | 800-2000 |
| Top freq. (MHz) | 50-800 | 50-400 | 50-250 |
| Bias power (W) | 0-1000 | 100-800 | 100-300 |
| Bias freq. | 10 KHz - 50 MHz | 100 KHz - 30 MHz | 5-15 MHz |
| Press. (mt) | $\leqq 500$ | 1-100 | 1-30 |
| Wafer temp. (°C) | - | - | - |
| Gas Chemistry (sccm) | | | |
| Etchant | Non-reactive | Ar | Ar |

Table 4

| POLY/OXIDE | | | | |
|---|---|---|---|---|
| Parameter | | Range | | |
| | | 1 | 2 | 3 |
| Top elect. power (W) | | 200-1500 | 300-1000 | 300-750 |
| Top freq. (MHz) | | 50-800 | 50-400 | 50-250 |
| Bias power (W) | | 0-500 | 0-300 | 0-200 |
| Bias freq. | | 10 KHz -50 MHz | 100 KHz -30 MHz | 5-15 MHz |
| Cathode Sheath (V) | | $\leq$ 200 | $\leq$ 100 | 50-100 |
| Press. (mt) | | $\leq$ 500 | 1-100 | 5-50 |
| Wafer temp. (°C) | (1) | > -40°C | | |
| | (2) | < -40°C | | |
| Gas Chemistry (sccm) | | | | |
| Etch | (1) | Cl or Br | $Cl_2$ or HBr or $BCL_3$ + Ar | $Cl_2$ 50-300 |
| | | | | He 50-300 |
| | | | | $O_2$ 0-20 |
| | (2) | F | $SF_6$ or $NF_3$ + Argon | $SF_6$ 30-300 |
| | | | | Ar 30-300 |

Table 5

| RIE ALUMINUM | | | |
|---|---|---|---|
| Parameter | Range | | |
| | 1 | 2 | 3 |
| Top elect. power (W) | 500-1500 | 600-800 | 600-800 |
| Top freq. (MHz) | 50-800 | 50-400 | 50-250 |
| Bias power (W) | 100-400 | 100-200 | 100-200 |
| Bias freq. | 10 KHz -50 MHz | 100 KHz -30 MHz | 5-15 MHz |
| Press. (mt) | $\leq$ 500 | 1-100 | 5-50 |
| Wafer temp. (°C) | $\leq$ 125 | - | |
| Gas Chemistry (sccm) | | | |
| Etch | $Cl_2/BCl_3$ | $Cl_2$ + $BCl_3$ | $Cl_2$=30-100 |
| | | | $BCl_3$=30-100 |
| Dopant | $BBr_3$ | | |

Table 6

| RIE SILICON | | | |
|---|---|---|---|
| Parameter | Range | | |
|  | 1 | 2 | 3 |
| Top elect. power (W) | 100-2500 | 300-700 | 300-700 |
| Top freq. (MHz) | 50-800 | 50-400 | 50-250 |
| Bias power (W) | 0-500 | 50-200 | 50-150 |
| Bias freq. | 10 KHz -50 MHz | 100 KHz -30 MHz | 5-15 MHz |
| Press. (mt) | $\leq$ 500 | 5-50 | 5-50 |
| Wafer temp. (°C) | $\leq$ 125 | $\leq$ 100 | $\leq$ 75 |
| Gas Chemistry (sccm) |  |  |  |
| Etchant | Halogen | $HBr/SiF_4/NF_3$ | HBr 30-100<br>$SiF_4$ 0-20<br>HBr 0-10 |
| Dopant |  | $He/O_2$ | $O_2$ 0-10<br>$NF_3$ 0-20 |

Table 7

| RIE TUNGSTEN | | |
|---|---|---|
| Parameter | Range | |
|  | 1 | 2 |
| Top elect. power (W) | 100-2500 | 200-500 |
| Top freq. (MHz) | 50-800 | 50-250 |
| Bias power (W) | 0-500 | 0-200 |
| Bias freq. | 10 KHz -50 MHz | 5 MHz -15 MHz |
| Press. (mt) | $\leq$ 500 | 10-100 |
| Wafer temp. (°C) | - | - |
| Gas Chemistry (sccm) |  |  |
| Etchant | F | $NF_3$ 0-200<br>$SF_6$ 0-200 |
| Dopant | Inert | Ar 0-200 |

Table 8

| ANISOTROPIC RIE PHOTORESIST | | | |
|---|---|---|---|
| Parameter | Range | | |
| | 1 | 2 | 3 |
| Top elect. power (W) | 300-2500 | 300-1500 | 300-1500 |
| Top freq. (MHz) | 50-800 | 50-400 | 50-250 |
| Bias power (W) | 0-500 | 0-300 | 0-200 |
| Bias freq. | 10 KHz -50 MHz | 100 KHz -30 MHz | 5-15 MHz |
| Press. (mt) | $\leq 500$ | 1-100 | 5-50 |
| Wafer temp. (°C) | | $\leq 125$ | $\leq 75$ |
| Gas Chemistry (sccm) | | | |
| Etchant | O | $O_2$ | 10-300 |
| Dopant | F | $CF_4$ | 0-300 |

Table 9

| RIE BARRIER LAYER TiW/TiN | | | |
|---|---|---|---|
| Parameter | Range | | |
| | 1 | 2 | 3 |
| Top elect. power (W) | 100-2500 | 300-1000 | 300-600 |
| Top freq. (MHz) | 50-800 | 50-400 | 50-250 |
| Bias power (W) | 0-500 | 0-200 | 100-200 |
| Bias freq. | 10 KHz -50 MHz | 100 KHz -30 MHz | 5-15 MHz |
| Press. (mt) | $\leq 500$ | 1-100 | 5-50 |
| Wafer temp. (°C) | | | |
| Gas Chemistry (sccm) | | | |
| Etch | Halogen | F + Cl | $CF_4$ 0-20 $BCl_3$ 10-100 $Cl_2$ 0-20 |

Table 10

| LIGHT ETCH | | |
|---|---|---|
| Parameter | Range | |
| | 1 | 2 |
| Top elect. power (W) | 100-1000 | 100-1000 |
| Top freq. (MHz) | 50-800 | 50-250 |
| Bias power (W) | 0-200 | 0-200 |
| Bias freq. | 10 KHz - 50 MHz | 5-15 MHz |
| Press. (mt) | $\leq 500$ | 5-100 |
| Wafer temp. (°C) | - | - |
| Gas Chemistry (sccm) | | |
| Oxide | F | $CF_4$ 30-120 or $NF_3$ 30-120 |
| Poly | Cl | $Cl_2$ 30-120 |

Table 11

| HP ISOTROPIC OXIDE ETCH | | | |
|---|---|---|---|
| Parameter | Range | | |
| | 1 | 2 | 3 |
| Top elect. power (W) | 500-5000 | 500-2500 | 500-2500 |
| Top freq. (MHz) | 50-800 | 50-400 | 50-250 |
| Bias power (W) | 0-500 | 0-300 | 0-300 |
| Bias freq. | 10 KHz -50 MHz | 100 KHz -30 MHz | 5-15 MHz |
| Press. (mt) | $\leq 500$ mt | 0.5-20 torr | 0.5-5 torr |
| Wafer temp. (°C) | $\leq 125$ | $\leq 100$ | 60-75 |
| Gas Chemistry (sccm) | | | |
| Etch | F | $CF_4$ $NF_3$ $SF_6$ $C_2F_6$ | $CF_4$ 500-2000 or $NF_3$ 500-2000 |

Table 12

| PHOTORESIST STRIP | | | |
|---|---|---|---|
| Parameter | Range | | |
| | 1 | 2 | 3 |
| Top elect. power (W) | 300-5000 | 300-2500 | 300-2500 |
| Top freq. (MHz) | 50-800 | 50-400 | 50-250 |
| Bias power (W) | 0-1000 | 0-1000 | 0-1000 |
| Bias freq. | 10 KHz - 50 MHz | 100 KHz - 30 MHz | 5 - 15 MHz |
| Press. (mt) | 100 mt -50 torr | 500 - mt 10 torr | 500 mt -5 torr |
| Wafer temp. (°C) | $\leq 300$ | $\leq 250$ | 100-200 |
| Gas Chemistry (sccm) | | | |
| Etchant | O | $O_2,N_2O$ | $O,N_2O$ 500-2000 |
| Dopant | F,N | $CF_4,NF_3,$ $SF_6,C_2F_6$ | $N_2$ 0-5000 $CF_4$ 0-500 $NF_3$ 0-500 |

Table 13

| LP PLASMA NITRIDE DEPOSITION | | | |
|---|---|---|---|
| Parameter | 1 | 2 | 3 |
| Top elect. power (W) | 300-5000 | 300-2500 | 300-2500 |
| Top freq. (MHz) | 50-800 | 50-400 | 50-250 |
| Bias power (W) | 0-1000 | 0-600 | 0-600 |
| Bias freq. | 10 KHz -50 MHz | 100 KHz -30 MHz | 5 - 15 MHz |
| Press. (mt) | $\leq 500$ | $\leq 50$ | $\leq 50$ |
| Wafer temp. (°C) | - | 100-500 | 200-400 |
| Gas Chemistry (sccm) | | | |
| | Si & N | $SiH_4$ $N_2$ $NH_3$ | 30-300 100-1000 0-50 |

Table 14

| LP PLASMA OXYNITRIDE DEPOSITION | | | |
|---|---|---|---|
| Parameter | 1 | 2 | 3 |
| Top elect. power (W) | 300-5000 | 300-2500 | 500-2500 |
| Top freq. (MHz) | 50-800 | 50-400 | 50-250 |
| Bias power (W) | 0-1000 | 0-600 | 0-600 |
| Bias freq. | 10 KHz -50 MHz | 100 KHz -30 MHz | 5 - 15 MHz |
| Press. (mt) | $\leq 500$ | $\leq 50$ | $\leq 50$ |
| Wafer temp. (°C) | - | 100-500 | 200-400 |
| Gas Chemistry (sccm) | | | |
| | Si | $SiH_4$ | 30-300 |
| | N | $N_2$ | 100-1000 |
| | O | $O_2/N_2O$ | 100-1000 |
| Dopant | | $NH_3$ | 0-50 |

## Table 15
## LP OXIDE DEPOSITION

| Parameter | 1 | 2 | 3 |
|---|---|---|---|
| Top elect. power (W) | 300-5000 | 500-2500 | 1000-2000 |
| Top freq. (MHz) | 50-800 | 50-400 | 50-250 |
| Bias power (W) | 0-1000 | 200-1000 | 200-1000 |
| Bias freq. | 10 KHz - 50 MHz | 100 KHz - 30 MHz | 5-15 MHz |
| Press. (mt) | $\leq$ 500 | 1-100 | 1-30 |
| Wafer temp. (°C) | $\leq$ 500 | 200-400 | 300-400 |
| Gas Chemistry (sccm) | | | |
| Si | Si | $SiH_4$/TEOS | $SiH_4$ 30-100 |
| O | O | $O_2/N_2O$ | $O_2$ 30-200 |
| Dopant | Inert | Ar | Ar 400-800 |

Table 16

| HP OXIDE/OXYNITRIDE DEPOSITION | | | |
|---|---|---|---|
| Parameter | 1 | 2 | 3 |
| Top elect. power (W) | 300-5000 | 300-2500 | 500-1500 |
| Top freq. (MHz) | 50-800 | 50-400 | 50-250 |
| Bias power (W) | 0-1000 | 0-300 | 0-300 |
| Bias freq. | 10 KHz -50 MHz | 100 KHz -30 MHz | 5 -15 MHz |
| Press. (mt) | $\geq$ 500 | 500 mt -50 torr | 1-10 torr |
| Wafer temp. (°C) | - | 100-500 | 200-400 |
| Gas Chemistry (sccm) | | | |
| Nitride | Si | $SiH_4$ | 30-100 |
| | N | $N_2O$ | 400-5000 |
| | | $NH_3$ | 0-30 |
| Oxynitride | Si | $SiH_4$ | 30-100 |
| | N | $N_2$ | 400-5000 |
| | O | $N_2O$ | 400-5000 |
| | | or $O_2$ | - |
| | | $NH_3$ | 0-30 |

Table 17

| HP CONFORMAL OXIDE DEPOSITION | | | |
|---|---|---|---|
| Parameter | 1 | 2 | 3 |
| Top elect. power (W) | 300-5000 | 300-2500 | 500-1500 |
| Top freq. (MHz) | 50-800 | 50-400 | 50-250 |
| Bias power (W) | 0-1000 | 0-1000 | 0-1000 |
| Bias freq. | 10 KHz -50 MHz | 100 KHz -30 MHz | 5 -15 MHz |
| Press. (mt) | > 500 | 500 mt -50 torr | 500 mt - 10 torr |
| Wafer temp. (°C) | - | 100-500 | 200-400 |
| Gas Chemistry (sccm) | | | |
| | Si | $SiH_4 + N_2O$ | 30-100 + 200-3000 $SiH_4 + N_2O$ |
| | O | $TEOS + O_2$ | 30-100 + 100-1000 $TEOS - O_2$ |
| | | $TEOS + N_2O$ | 30-100 + 100-1000 $TEOS\ N_2O$ |

**Claims**

1. A system for processing a workpiece (5), comprising: an enclosure (11) defining a vacuum processing chamber (16); means (22) for introducing process gas into the chamber (16); electrode means (25,32c) for coupling AC electrical energy into the chamber to generate a plasma in the gas; means (27,28) for applying high frequency VHF/UHF electrical energy to the electrode means (25,32c), controlling the density of the plasma; and means (41,42) for applying relatively lower frequency AC electrical energy to the electrode means, controlling the sheath voltage associated with the electrode means and plasma ion energy.

2. The system (120) of Claim 1, wherein the electrode means (25,32c) comprises two electrode structures (25P and 32C) for applying plasma generating AC electrical energy to the chamber, the means (27,28) for applying the high frequency AC electrical energy being connected to one of the electrode structures (25P) and the means (41,42) for applying the relatively lower frequency AC electrical energy being connected to the other (32c) of the two electrode structures.

3. The system (130) of Claim 1 (17P), wherein the enclosure (11) includes a dielectric window (17P) in one surface thereof; the electrode means comprises a wafer support electrode (32c) within the chamber (16) and a plate electrode (25P) on the dielectric window (17P); the means (41,42) for applying the relatively low frequency AC energy is connected to the wafer support electrode (32c); the means (27,28) for applying high frequency AC energy is connected to the chamber enclosure; the plate electrode (25P) is at system ground; and both means for applying AC electrical energy are referenced to the plate electrode as ground, whereby the electrodes form an electric field in the chamber between the wafer support electrode (32c) and the plate electrode (25P).

4. The system (140) of Claim 1, wherein the electrode means comprises a single electrode structure (32c) located within the chamber and adapted for supporting a workpiece, and wherein both means (27,28;41,42) for applying AC electrical energy to the electrode means are connected to the single electrode structure (32c).

5. The system (120) of Claim 1, wherein the enclosure (11) includes a dielectric window (17P) in one surface thereof; the electrode means comprises a wafer support electrode (32c) within the chamber and a plate electrode (25P) on the dielectric window (17P); the means for applying high frequency AC electrical energy is connected to the plate electrode; the means (41,42) for applying the relatively low frequency AC energy is connected to the wafer support electrode (32c); and both means for applying AC energy are referenced to the chamber enclosure as ground, whereby the electrodes form an electric field in the chamber between the wafer support electrode (32c) and the plate electrode (25P).

6. The system of Claim 1, wherein the electrode means comprises an electrode (32c) located within the chamber (16) and adapted for supporting a workpiece (5) thereon and an electrode structure (25) surrounding the periphery of the plasma chamber (16); the means (27,28) for applying high frequency AC energy is connected to the peripheral electrode structure (25); and the means (41,42) for applying relatively lower frequency AC energy is connected to the wafer support electrode (32c).

7. The system of Claim 5, wherein the enclosure includes a dielectric dome (17) internally defining a section (16B) of the chamber (16); the peripheral electrode structure (25) surrounds the chamber section (16B) defined within the dome (17); and the peripheral electrode structure (25) and the wafer support electrode (32c) are positioned for forming an electric field in the chamber (16) parallel to the wafer support electrode (32c).

8. The system of Claim 7, wherein the peripheral electrode structure (25) is located on the interior of the dome (17) and is covered on the inside by dielectric.

9. The system of 7, wherein the peripheral electrode structure (25) is formed on the exterior of the dome.

10. The system of one of Claims 7 to 9, wherein the peripheral electrode structure (25) comprises separate sections (26) and, in combination with the means (27,28) for applying the high frequency AC electrical energy, provides a differentially driven, ungrounded, balanced drive arrangement for the electrode structure.

11. The system of one of the preceding claims, wherein the frequency of the high frequency AC energy is within the range of about 50 MHz to about 800 MHz, and the frequency of the relatively lower frequency AC energy is within the range of about 0.1 MHz to about 50 MHz.

12. The system of any of Claims 5 to 11, further comprising means (47) for applying a static magnetic field orthogonal to the plane of the peripheral electrode structure selected from uniform (81), diverging (82) and magnetic mirror field (83;84) configurations for controlling the location and transport of the plasma relative to the wafer (5).

13. The system of Claim 12, further comprising magnetic shunt means proximate the wafer support electrode for diverting the static magnetic field from the wafer support electrode to provide a relatively lower intensity field region along the wafer support surface.

14. The system of any of Claims 3 or 5 to 11, further comprising an integral transmission line structure (32) adapted to apply AC electrical energy of selected frequency from an external source to the plasma chamber (16), comprising: the wafer support electrode (32c); an outer conductor (32o) surrounding the wafer support electrode (32c); and an insulator (32l) between the wafer support electrode (32c) and the outer conductor (32o) such that AC energy applied to the transmission line structure is coupled along the wafer support electrode for controlling the cathode sheath voltage.

15. The system of any of Claims 3 or 5 to 11, wherein the wafer support electrode (32c) includes a surface for supporting a wafer thereon and further comprising means for applying a multipolar cusp field (84) in a lower chamber region (16A) for providing a relatively high intensity field region about the periphery inside the chamber walls and a relatively lower intensity field region along the wafer support surface.

16. The system of any of Claims 3 to 11, further comprising a reflector (44) external to the enclosure (11) and surrounding the electrode means (25) for preventing radiation of the high frequency energy into free space.

17. The system of any of one of the preceding claims, wherein the high frequency AC electrical energy is coupled to the electrode means via one of inductive, capacitive and conductive impedance for matching the impedance of the electrode means to the high frequency source.

18. The system of one of claims 6 to 16 wherein the high frequency energy is coupled to the surrounding electrode via one of inductive, capacitive and conductive impedance for matching the impedance of the surrounding electrode to the high frequency source.

19. The system of one of claims 6 to 16, wherein the high frequency energy is coupled to the surrounding electrode through a variable capacitor for matching the impedance of the surrounding electrode to that of the high frequency source.

20. The system of any of the preceding claims further comprising a biased grid for extracting a stream of charged ions or electrons from the plasma.

21. The system of Claim. 20, further comprising a neutralization grid spaced from the extraction grid for extracting a stream of excited neutrals and free radicals.

22. A system for processing a workpiece in a plasma especially according to one of the preceding claims, comprising: an enclosure (11) defining a vacuum chamber (16); means (22) for introducing gas into the chamber (16); electrode means comprising two electrode structures (25;32c) for coupling AC electrical energy into the chamber to generate a plasma in the gas; means (27,28) for applying high frequency AC electrical energy of frequency within the range of about 50 MHz to about 800 MHz to the electrode means, thereby controlling the density of the plasma; and means (41,42) for applying relatively lower frequency AC electrical energy of frequency selected from the range of about 0.1 MHz to about 50 MHz to the electrode means, thereby controlling sheath voltage associated with the electrode means and plasma ion energy.

FIG-1

FIG.-2

FIG.-3

FIG.-4

FIG-5

FIG-8A

FIG-8B

FIG-8C

FIG-8D

FIG-6

FIG-7

TO 27
$z_{IN}$

50

IN

57

58

$C_1$

56

55

$L_1$

52

70

OUT

$C_2$

TO
$z_L$

**FIG-9**

TO SPLIT ELECTRODE 25

76

77

74

73

72

75

70

λ/4

28

64

64

51

53

52

55

$C_2$

54

59

56

$C_1$

57

50

62

58

61

**FIG-10**

$C_1$

$C_2$

TO
ELECTRODE 32

$M_1$

$M_2$

500

COMPUTER

SUPPLY

504

**FIG-11**

European Patent
Office

**EUROPEAN SEARCH REPORT**

Application Number

EP 96 10 2011

## DOCUMENTS CONSIDERED TO BE RELEVANT

| Category | Citation of document with indication, where appropriate, of relevant passages | Relevant to claim | CLASSIFICATION OF THE APPLICATION (Int.Cl.5) |
|---|---|---|---|
| X | EP-A-0 403 418 (PLASMA & MATERIALS TECHNOLOGIE) 19 December 1990 * column 9, line 39 - column 10, line 18; figures 6,12-16 * | 1 | H01J37/32 H05H1/46 |
| A | US-A-4 859 908 (YOSHIDA AKIHISA ET AL) 22 August 1989 * column 5, line 49 - column 6, line 68; figures 1,2,5 * | 1,2 | |
| A | US-A-4 622 094 (OTSUBO TORU) 11 November 1986 * abstract * | 1 | |

TECHNICAL FIELDS
SEARCHED (Int.Cl.5)

H01J
H05H

The present search report has been drawn up for all claims

| Place of search | Date of completion of the search | Examiner |
|---|---|---|
| THE HAGUE | 25 March 1996 | Schaub, G |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)